# EUROPEAN PATENT APPLICATION

(11) **EP 2 455 992 A1**
(43) Date of publication of application: **23.05.2012**
(21) Application number: 10799909.6
(22) Date of filing: 12.07.2010
(51) Int. Cl.: H01L 51/50, C07C 69/618, C08G 61/10, C08K 3/04, C08L 65/00, C09K 11/06

(54) **ORGANIC ELECTROLUMINESCENT ELEMENT AND HIGH-MOLECULAR LIGHT-EMITTING COMPOSITION**

(30) Priority: 14.07.2009 JP 2009165364; 21.01.2010 JP 2010010742
(71) Applicant: Sumitomo Chemical Company, Limited, Tokyo 104-8260 (JP)
(72) Inventor: UETANI, Yasunori, Tsukuba-shi Ibaraki 305-0045 (JP)
(74) Representative: Duckworth, Timothy John
(86) International application number: PCT/JP2010/062027
(87) International publication number: WO 2011/007851

(57) **Abstract**

An organic electroluminescent element comprising: a pair of electrodes composed of an anode and a cathode; and a light-emitting layer provided between the electrodes, wherein the light-emitting layer comprises a light emitting polymer having one or more kinds of diyl group, as a repeating unit, selected from the group consisting of an unsubstituted or substituted fluorenediyl group and an unsubstituted or substituted benzofluorenediyl group, and a fullerene and/or a fullerene derivative.

## Description

### Technical Field

The present invention relates to an organic electroluminescent element (hereinafter may be referred to as an organic EL element), a light emitting polymer composition used for the organic EL element, and a light-emitting device.

### Background Art

An organic EL element is a light-emitting element that comprises a pair of electrodes composed of an anode and a cathode, and a light-emitting layer provided between the electrodes. When a voltage is applied between the electrodes in the organic EL element, holes are injected from the anode and electrons are injected from the cathode. The holes and the electrons combine in the light-emitting layer, thereby emitting light.

Organic EL elements use an organic material for a light-emitter that is contained in the light-emitting layer. Since a light emitting polymer (high molecular weight light-emitting material) is relatively easy to dissolve in a solvent, an applying method can be employed to form the light-emitting layer. Since the applying method is a film formation method capable of forming a light-emitting layer of large surface area and the steps thereof are simple, the applying method is suited to the demands for large scale elements and simple steps. Consequently, various light emitting polymers have been proposed in recent years (for example, Advanced Materials Vol. 12, 1737-1750 (2000)).

### Disclosure of the Invention

It is desirable for organic EL elements to have a low degree of deterioration over time in brightness as a result of being driven, or in other words, to have a long element life. However, the life of an organic EL element that uses a light emitting polymer is still not sufficient. Therefore, there is a need for further improvement in element life.

It is an object of the present invention to provide an organic EL element having a long element life, and a light emitting polymer composition for use in the organic EL element.

The present invention provides the following organic EL element and light emitting polymer composition.

[1] An organic electroluminescent element comprising: a pair of electrodes composed of an anode and a cathode; and a light-emitting layer provided between the electrodes, wherein the light-emitting layer comprises,
a light emitting polymer having one or more kinds of diyl group, as a repeating unit, selected from the group consisting of an unsubstituted or substituted fluorenediyl group and an unsubstituted or substituted benzofluorenediyl group, and
a fullerene and/or a fullerene derivative.

[2] The organic electroluminescent element according to [1], wherein the fullerene derivative is a methanofullerene derivative, a phenyl butyric acid methyl ester derivative, a thienyl butyric acid methyl ester derivative, a Prato derivative, a Bingel derivative, a diazoline derivative, an azafulleroid derivative, a ketolactam derivative, or a Diels-Alder derivative.

[3] The organic electroluminescent element according to [1] or [2], wherein the unsubstituted or substituted fluorenediyl group is a group represented by formula (1): 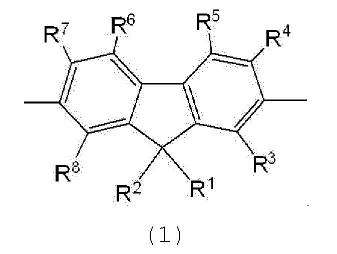 wherein R¹, R², R³, R⁴, R⁵, R⁶, R⁷ and R⁸ each independently represent a hydrogen atom, an alkyl group, an alkoxy group, an aryl group, or a monovalent aromatic heterocyclic group; and a hydrogen atom included in these groups may be substituted with a fluorine atom.

[4] The organic electroluminescent element according to any one of [1] to [3], wherein the unsubstituted or substituted benzofluorenediyl group is a group represented by the following formula (2): 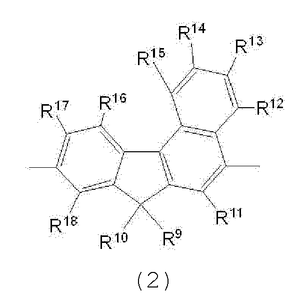 wherein R⁹, R¹⁰, R¹¹, R¹², R¹³, R¹⁴ , R¹⁵ , R¹⁶ , R¹⁷ and R¹⁸ each independently represent a hydrogen atom, an alkyl group, an alkoxy group, an aryl group, or a monovalent aromatic heterocyclic group; and a hydrogen atom included in these groups may be substituted with a fluorine atom.

[5] The organic electroluminescent element according to any one of [1] to [4], wherein the light emitting polymer is a conjugated macromolecule.

[6] The organic electroluminescent element according to any one of [1] to [5], wherein a content of the fullerene and/or fullerene derivative in the light-emitting layer is from 0.001 part by weight to 5 parts by weight with respect to 100 parts by weight of the light emitting polymer.

[7] The organic electroluminescent element according to any one of [1] to [5], wherein a content of the fullerene and/or fullerene derivative in the light-emitting layer is from 0.01 part by weight to 1 part by weight with respect to 100 parts by weight of the light emitting polymer.

[8] A light-emitting device comprising the organic electroluminescent element of any one of [1] to [7].

[9] A light emitting polymer composition, comprising:
a light emitting polymer having one or more kinds of diyl group, as a repeating unit, selected from the group consisting of an unsubstituted or substituted fluorenediyl group and an unsubstituted or substituted benzofluorenediyl group; and
a fullerene and/or a fullerene derivative.

[10] The light emitting polymer composition according to [9], wherein the fullerene derivative is a methanofullerene derivative, a phenyl butyric acid methyl ester derivative, a thienyl butyric acid methyl ester derivative, a Prato derivative, a Bingel derivative, a diazoline derivative, an azafulleroid derivative, a ketolactam derivative, or a Diels-Alder derivative.

[11] The light emitting polymer composition according to [9] or [10], wherein the unsubstituted or substituted fluorenediyl group is a group represented by formula (1): 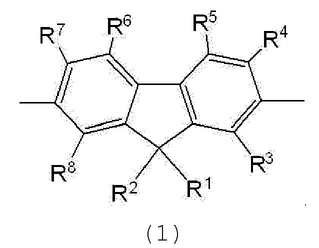 wherein R¹, R², R³, R⁴, R⁵, R⁶, R⁷ and R⁸ each independently represent a hydrogen atom, an alkyl group, an alkoxy group, an aryl group, or a monovalent aromatic heterocyclic group; and a hydrogen atom included in these groups may be substituted with a fluorine atom.

[12] The light emitting polymer composition according to any one of [9] to [11], wherein the unsubstituted or substituted benzofluorenediyl group is a group represented by the following formula (2): 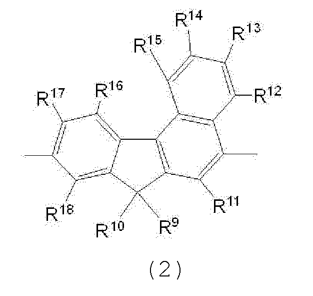 wherein R⁹, R¹⁰, R¹¹, R¹², R¹³, R¹⁴ , R¹⁵, R¹⁶, R¹⁷ and R¹⁸ each independently represent a hydrogen atom, an alkyl group, an alkoxy group, an aryl group, or a monovalent aromatic heterocyclic group; and a hydrogen atom included in these groups may be substituted with a fluorine atom.

[13] The light emitting polymer composition according to any one of [9] to [12], wherein the light emitting polymer is a conjugated macromolecule.

[14] The light emitting polymer composition according to any one of [9] to [13], wherein a content of the fullerene and/or fullerene derivative is from 0.001 part by weight to 5 parts by weight with respect to 100 parts by weight of the light emitting polymer.

[15] The light emitting polymer composition according to any one of [9] to [13], wherein a content of the fullerene and/or fullerene derivative is from 0.01 part by weight to 1 part by weight with respect to 100 parts by weight of the light emitting polymer.

### Embodiments for Carrying Out the Invention

The organic EL element of the present invention comprises a pair of electrodes composed of an anode and a cathode, and a light-emitting layer provided between the electrodes.

The light-emitting layer comprises a light emitting polymer having one or more kinds of diyl group selected from the group consisting of an unsubstituted or substituted fluorenediyl group and an unsubstituted or substituted benzofluorenediyl group as a repeating unit, and a fullerene and/or fullerene derivative. The light-emitting layer may comprise two or more kinds of fullerene, and may comprise two or more kinds of fullerene derivative.

The fullerene contained in the light-emitting layer may include C₆₀, C₇₀, and carbon nanotubes. Examples of the fullerene derivative may include a methanofullerene derivative, a PCBM derivative (a phenyl butyric acid methyl ester derivative), a ThCBM derivative (a thienyl butyric acid methyl ester derivative), a Prato derivative, a Bingel derivative, a diazoline derivative, an azafulleroid derivative, a ketolactam derivative, and a Diels-Alder derivative (for example, see JP 2009-542725 A).

Methanofullerene Derivative: 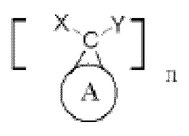 wherein A represents a fullerene skeleton (preferably, a C60 fullerene skeleton or a C70 fullerene skeleton);
the -C(X)(Y)- group is bonded to the fullerene skeleton via a methano crosslink; X and Y represent an aryl group having 6 to 60 carbon atoms, an alkyl group having 1 to 20 carbon atoms, or some other chemical groups (for example, an alkoxycarbonylalkyl group having 3 to 20 carbon atoms); and n represents 1 or 2.

Specific examples may include a compound (PCBM) in which X is an unsubstituted aryl and Y is a butyric acid methyl ester.

PCBM Derivative: 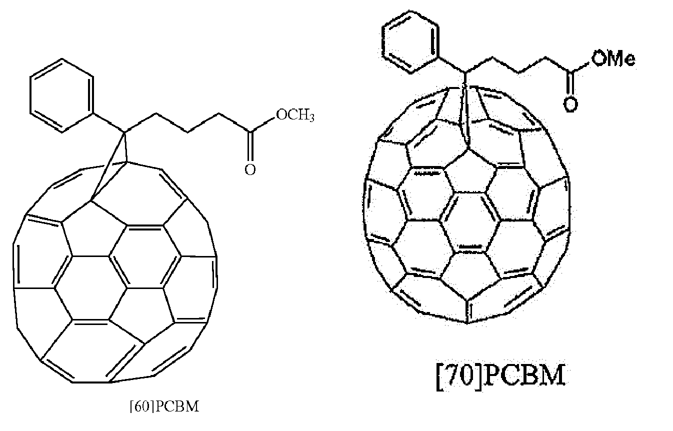 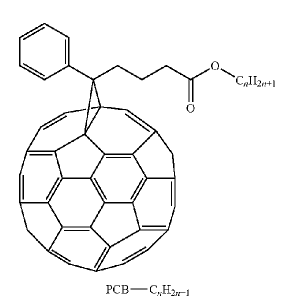 wherein n represents an integer from 1 to 20.

ThCBM Derivative: 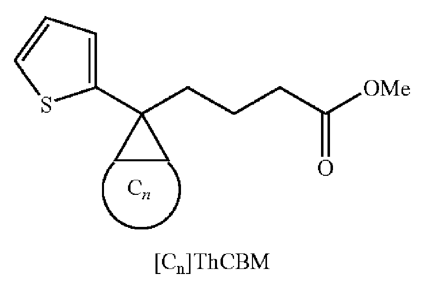 wherein Cn represents a fullerene skeleton (preferably, a C60 fullerene skeleton or a C70 fullerene skeleton).

Prato derivative: 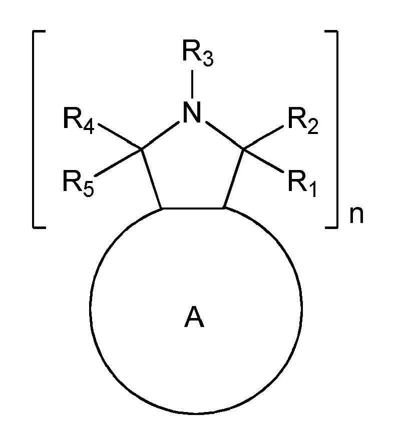 wherein A is a fullerene skeleton (preferably, a C60 fullerene skeleton or a C70 fullerene skeleton) bonded to - C(R4R5)-N(R3)-C(R1R2)-;
R1 is an optionally substituted aryl having 6 to 60 carbon atoms or aralkyl having 7 to 60 carbon atoms;
R2, R3, R4 and R5 independently represent an optionally substituted alkyl having 1 to 20 carbon atoms, an optionally substituted cycloalkyl having 3 to 60 carbon atoms, an optionally substituted heteroalkyl having 1 to 20 carbon atoms, an optionally substituted heterocycloalkyl having 2 to 60 carbon atoms, an optionally substituted alkenyl having 1 to 20 carbon atoms, or an optionally substituted aralkyl having 7 to 60 carbon atoms; and
n is from 1 to 40.

Among these, 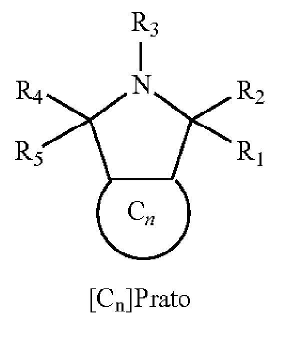 is preferred. Here, Cn represents a fullerene skeleton (preferably, a C60 fullerene skeleton or a C70 fullerene skeleton) .

Bingel Derivative: 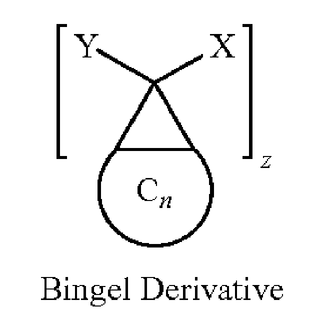 wherein
Cn represents a fullerene skeleton (preferably, a C60 fullerene skeleton or a C70 fullerene skeleton);
z is from 1 to 40;
X is an electron withdrawing group (EWG) such as an ester having 1 to 20 carbon atoms, a nitrile, a nitro, a cyano, a ketone having 1 to 20 carbon atoms, a dialkylphosphate having 2 to 20 carbon atoms, a (substituted) pyridine, and C-≡-C-R (also known as acetylene), wherein R is Si-(R)3 or a trisubstituted silyl group (which may be the same as or different from each other); and
Y is H, an aryl having 6 to 60 carbon atoms, a substituted aryl having 6 to 60 carbon atoms, an alkyl having 1 to 20 carbon atoms, or a substituted alkyl having 1 to 20 carbon atoms.

Azafulleroid Derivative: 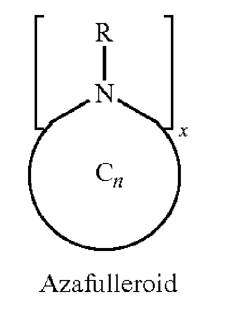 wherein
Cn represents a fullerene skeleton (preferably, a C60 fullerene skeleton or a C70 fullerene skeleton);
x is from 1 to 40; and
R is an alkyl having 1 to 20 carbon atoms, a substituted alkyl having 1 to 20 carbon atoms, an aryl having 6 to 60 carbon atoms, a substituted aryl having 6 to 60 carbon atoms, or S02-R', wherein R' is an alkyl having 1 to 20 carbon atoms, an aryl having carbon atoms, or a substituted aryl having 6 to 60 carbon atoms.

Diazoline Derivative: 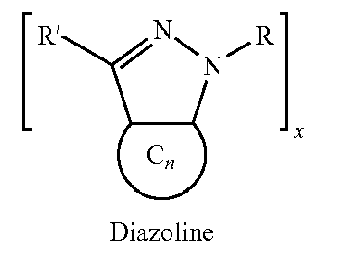 wherein Cn represents a fullerene skeleton (preferably, a C60 fullerene skeleton or a C70 fullerene skeleton);
R and R' independently represent an aryl having 6 to 60 carbon atoms; and
x is from 1 to 40.

Ketolactam Derivative: 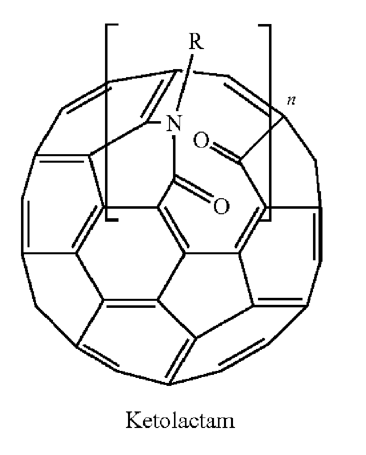 wherein
R is an alkyl or a substituted alkyl; and
n is from 1 to 40.

Diels-Alder Derivative: 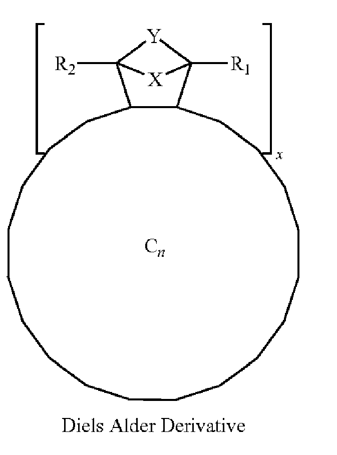 wherein
x is from 1 to 40;
Cn represents a fullerene skeleton (preferably, a C60 fullerene skeleton or a C70 fullerene skeleton);
R1 is H, an alkyl having 1 to 20 carbon atoms, an alkyloxy having 1 to 20 carbon atoms, an aryl having 6 to 60 carbon atoms, a substituted alkyl having 1 to 20 carbon atoms, a substituted aryl having 6 to 60 carbon atoms, a heteroaryl having 6 to 60 carbon atoms, or a substituted heteroaryl having 6 to 60 carbon atoms;
R2 is H, an alkyl having 1 to 20 carbon atoms, an alkyloxy having 1 to 20 carbon atoms, an aryl having 6 to 60 carbon atoms, a substituted alkyl having 1 to 20 carbon atoms, a substituted aryl having 6 to 60 carbon atoms, a heteroaryl having 6 to 60 carbon atoms, or a substituted heteroaryl having 6 to 60 carbon atoms;
X is O, an alkyl having 1 to 20 carbon atoms, a substituted alkyl having 1 to 20 carbon atoms, an aryl having 6 to 60 carbon atoms, a substituted aryl having 6 to 60 carbon atoms, a heteroaryl having 5 to 60 carbon atoms, or a substituted heteroaryl having 5 to 60 carbon atoms; and
Y represents an aryl having 6 to 60 carbon atoms, a substituted aryl having 6 to 60 carbon atoms, a heteroaryl having 5 to 60 carbon atoms, a substituted heteroaryl having 5 to 60 carbon atoms, a vinylene, or a substituted vinylene having 2 to 20 carbon atoms. 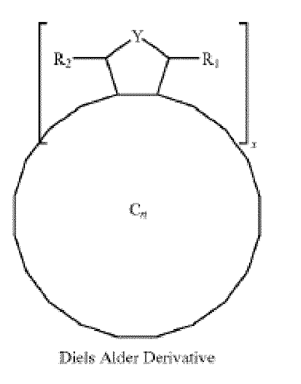 wherein
x is from 1 to 40;
Cn represents a fullerene skeleton (preferably, a C60 fullerene skeleton or a C70 fullerene skeleton);
R1 is H, an alkyl having 1 to 20 carbon atoms, an alkyloxy having 1 to 20 carbon atoms, an aryl having 6 to 60 carbon atoms, a substituted alkyl having 1 to 20 carbon atoms, a substituted aryl having 6 to 60 carbon atoms, a heteroaryl having 5 to 60 carbon atoms, or a substituted heteroaryl having 5 to 60 carbon atoms;
R2 is H, an alkyl having 1 to 20 carbon atoms, an alkyloxy having 1 to 20 carbon atoms, an aryl having 6 to 60 carbon atoms, a substituted alkyl having 1 to 20 carbon atoms, a substituted aryl having 6 to 60 carbon atoms, a heteroaryl having 5 to 60 carbon atoms, or a substituted heteroaryl having 5 to 60 carbon atoms; and
Y is an aryl having 6 to 60 carbon atoms, a substituted aryl having 6 to 60 carbon atoms, a heteroaryl having 5 to 60 carbon atoms, a substituted heteroaryl having 5 to 60 carbon atoms, a vinylene, or a substituted vinylene having 2 to 20 carbon atoms.

Specific examples may include the following.

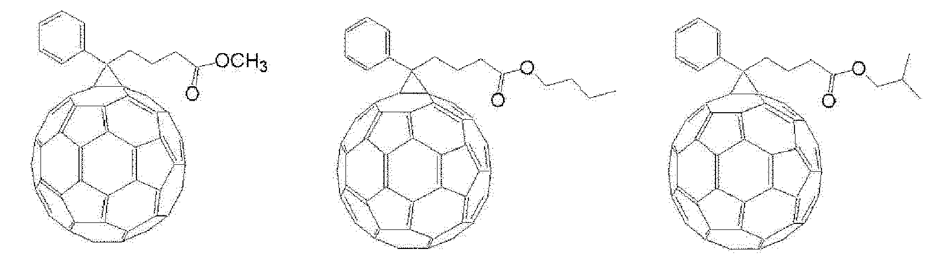

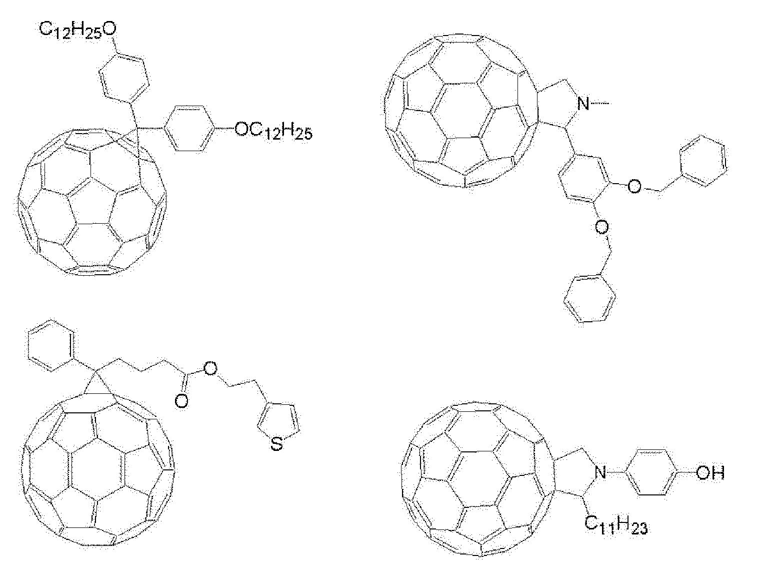

Next, the light emitting polymer used in the present invention will be described. The light emitting polymer used in the present invention has one or more kinds of diyl group, as a repeating unit, selected from the group consisting of an unsubstituted or substituted fluorenediyl group and an unsubstituted or substituted benzofluorenediyl group.

The unsubstituted or substituted fluorenediyl group repeating unit is, for example, represented by the following formula (1): 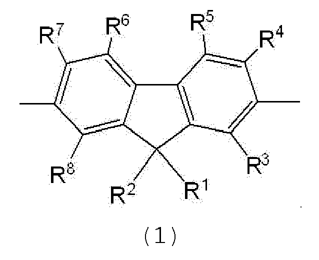 wherein R¹, R², R³, R⁴, R⁵, R⁶, R⁷ and R⁸ each independently represent a hydrogen atom, an alkyl group, an alkoxy group, an aryl group, or a monovalent aromatic heterocyclic group; and a hydrogen atom included in these groups may be substituted with a fluorine atom.

The unsubstituted or substituted benzofluorenediyl group repeating unit is, for example, represented by the following formula (2): 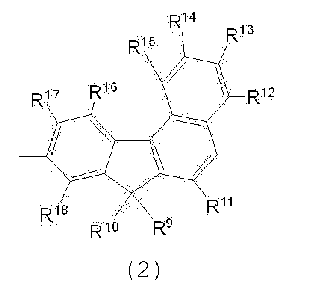 wherein R⁹, R¹⁰, R¹¹, R¹², R¹³, R¹⁴, R¹⁵, R¹⁶, R¹⁷ and R¹⁸ each independently represent a hydrogen atom, an alkyl group, an alkoxy group, an aryl group, or a monovalent aromatic heterocyclic group; and a hydrogen atom included in these groups may be substituted with a fluorine atom.

The alkyl group represented by R¹ to R¹⁸ in the formulae (1) and (2) may be linear or branched, and may also be a cycloalkyl group. The alkyl group usually has about 1 to 20 carbon atoms.

Examples of the alkyl group may include a methyl group, an ethyl group, an n-propyl group, an i-propyl group, an n-butyl group, an i-butyl group, a t-butyl group, an s-butyl group, a 3-methylbutyl group, an n-pentyl group, an n-hexyl group, a 2-ethylhexyl group, an n-heptyl group, an n-octyl group, an n-nonyl group, an n-decyl group, a 3,7-dimethyloctyl group, an n-lauryl group and the like. A hydrogen atom in the alkyl group may be substituted with a fluorine atom. Examples of the alkyl group substituted with a fluorine atom may include a trifluoromethyl group, a pentafluoroethyl group, a perfluorobutyl group, a perfluorohexyl group, a perfluorooctyl group and the like.

The alkoxy group represented by R¹ to R¹⁸ in the formulae (1) and (2) may be linear or branched, and may also be a cycloalkyloxy group. The alkoxy group usually has about 1 to 20 carbon atoms. Examples of the alkoxy group may include a methoxy group, an ethoxy group, an n-propyloxy group, an i-propyloxy group, an n-butoxy group, an i-butoxy group, an s-butoxy group, a t-butoxy group, an n-pentyloxy group, an n-hexyloxy group, a cyclohexyloxy group, an n-heptyloxy group, an n-octyloxy group, a 2-ethylhexyloxy group, an n-nonyloxy group, an n-decyloxy group, a 3,7-dimethyloctyloxy group, an n-lauryloxy group and the like. A hydrogen atom in the alkoxy group may be substituted with a fluorine atom. Examples of the alkoxy group substituted with a fluorine atom may include a trifluoromethoxy group, a pentafluoroethoxy group, a perfluorobutoxy group, a perfluorohexyl group, a perfluorooctyl group and the like.

The aryl group represented by R¹ to R¹⁸ in the formulae (1) and (2) is an atomic group formed by removing one hydrogen atom from an aromatic hydrocarbon. The aryl group may include a group having a fused ring, or a group in which two or more independent benzene rings or fused rings are directly bound or are bound via a vinylene group or the like. The aryl group usually has about 6 to 60 carbon atoms, and preferably 6 to 48 carbon atoms. The aryl group may have a substituent. The substituent may include a linear or branched alkyl group having 1 to 20 carbon atoms; a cycloalkyl alkyl group having 1 to 20 carbon atoms; an alkoxy group that includes in its structure a linear or branched alkyl group having 1 to 20 carbon atoms or a cycloalkyl alkyl group having 1 to 20 carbon atoms; a group represented by the formula (3) below; and a group represented by the formula (4) below. Examples of the aryl group may include a phenyl group, a C₁-C₁₂ alkoxyphenyl group (C₁-C₁₂ represents that the number of carbon atoms is from 1 to 12. The same shall apply hereinafter.), a C₁-C₁₂ alkylphenyl group, a 1-naphthyl group, a 2-naphthyl group, a 1-anthracenyl group, a 2-anthracenyl group, a 9-anthracenyl group, a pentafluorophenyl group and the like. Preferred are a C₁-C₁₂ alkoxyphenyl group and a C₁-C₁₂ alkylphenyl group. Specifically, the C₁-C₁₂ alkoxyphenyl group may include a methoxypheny group, an ethoxyphenyl group, an n-propyloxyphenyl group, an isopropyloxyphenyl group, an n-butoxyphenyl group, an isobutoxyphenyl group, an s-butoxyphenyl group, a t-butoxyphenyl group, an n-pentyloxyphenyl group, an n-hexyloxyphenyl group, a cyclohexyloxyphenyl group, an n-heptyloxyphenyl group, an n-octyloxyphenyl group, a 2-ethylhexyloxyphenyl group, an n-nonyloxyphenyl group, an n-decyloxyphenyl group, a 3,7-dimethyloctyloxy phenyl group, an n-lauryloxyphenyl group and the like. Specifically, the C₁-C₁₂ alkylphenyl group may include a methylphenyl group, an ethylphenyl group, a dimethylphenyl group, an n-propylphenyl group, a mesityl group, a methylethylphenyl group, an isopropylphenyl group, an n-buthylphenyl group, an isobutylphenyl group, an s-buthylphenyl group, a t-buthylphenyl group, an n-pentylphenyl group, an isoamylphenyl group, a hexylphenyl group, an n-heptylphenyl group, an n-octylphenyl group, an n-nonylphenyl group, an n-decylphenyl group, an n-dodecylphenyl group and the like. A hydrogen atom in the aryl group may be substituted with a fluorine atom.

-O-(CH₂)_{g}-O-(CH₂)ₕ-CH₃ (3)

(In formula (3), g represents an integer from 1 to 6, and h represents an integer from 0 to 5.) 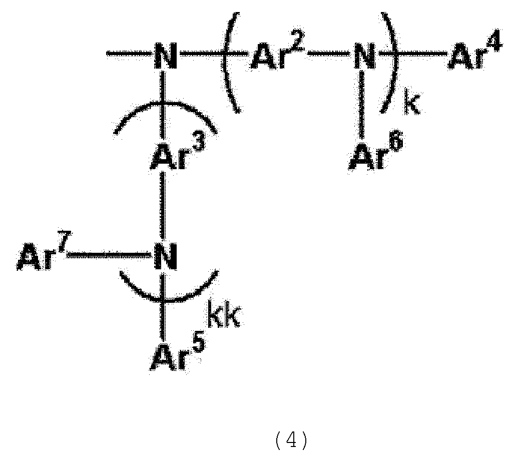 [In formula (4), Ar² and Ar³ each independently represent an arylene group or a divalent group in which two or more arylene groups, which are the same as or different from each other, are bonded each other via a single bond; Ar⁴, Ar⁵, Ar⁶ and Ar⁷ each independently represent an aryl group or a monovalent aromatic heterocyclic group; a group selected from among the groups represented by Ar³, Ar⁶ and Ar⁷ may be bonded, via a single bond or via -O-, -S-, -C(=O)-, -C(=O)-O-, -N(R¹⁹)-, -C(=O)-N(R¹⁹)-, or -C(R¹⁹)(R¹⁹)-, to a group selected from among the groups represented by Ar², Ar³, Ar⁴, Ar⁵, Ar⁶ and Ar⁷ which is bonded to the same nitrogen atom to which the former group selected is bonded, thereby forming a 5- to 7-membered ring; R¹⁹ represents a hydrogen atom, an alkyl group, an aryl group, or a monovalent aromatic heterocyclic group; the groups represented by Ar², Ar³, Ar⁴, Ar⁵, Ar⁶, Ar⁷ and R¹⁹ each may be substituted with an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, or a cyano group; k and kk each represents an integer from 0 to 3, provided that at least one of k and kk is an integer from 1 to 3; and the group that is plurally present, among Ar², Ar³, Ar⁴, Ar⁵, Ar⁶, Ar⁷ and R¹⁹, may be the same as or different from each other.]

The monovalent aromatic heterocyclic group in the formulae (1), (2) and (4) usually has about 3 to 60 carbon atoms, and preferably 3 to 20 carbon atoms. The number of carbon atoms does not include carbon atoms in a substituent. The monovalent aromatic heterocyclic group may include a 2-oxadiazole group, a 2-thiadiazole group, a 2-thiazole group, a 2-oxazol group, a 2-thienyl group, a 2-pyrrolyl group, a 2-furyl group, a 2-pyridyl group, a 3-pyridyl group, a 4-pyridyl group, a 2-pyrazyl group, a 2-pyrimidyl group, a 2-triazyl group, a 3-pyridazyl group, a quinolyl group, an isoquinolyl group, a 2-carbazolyl group, a 3-carbazolyl group, a 2-phenoxazinyl group, a 3-phenoxazinyl group, a 2-phenothiazinyl group, a 3-phenothiazinyl group and the like.

The aryl group represented by R¹ to R¹⁸ may have a substituent. From the perspective of the color purity in EL emission, especially from the perspective of blue color purity, it is preferred that the aryl group has a substituent represented by the formula (4).

When the aryl group has a substituent represented by the formula (4), this aryl group may be bonded via a single bond or via -O-, -S-, -C(=O)-, -C(=O)-O-, -N(R¹⁹)-, -C(=O)-N(R¹⁹)-, or -C(R¹⁹)(R¹⁹)- to a group selected from among the groups represented by Ar², Ar³, Ar⁴ and Ar⁵ in the formula (4) to form a 5- to 7-member ring.

Examples of the aryl group having a substituent represented by the formula (4) may include the groups represented by the formulae below; and these groups substituted with a group selected from the group consisting of an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, and a cyano group. 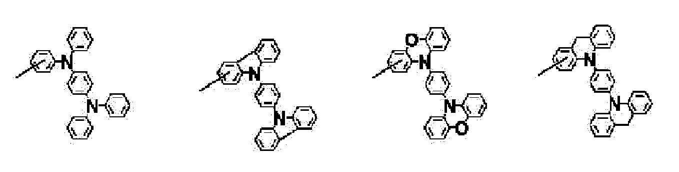 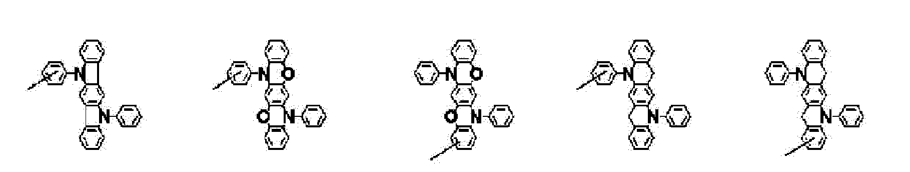 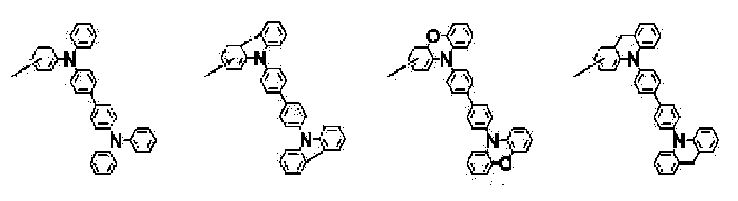 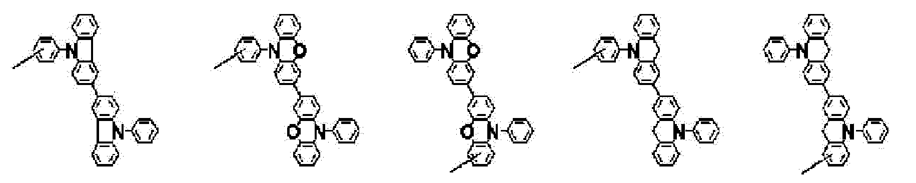 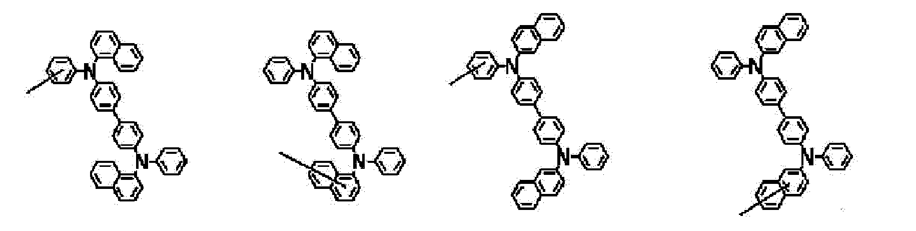 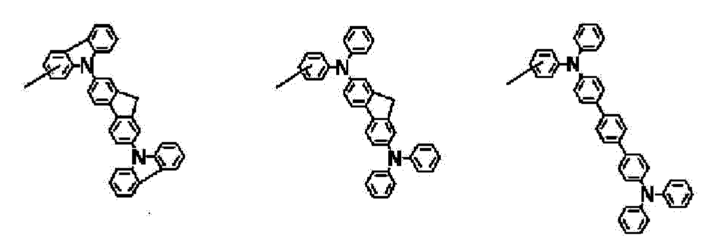 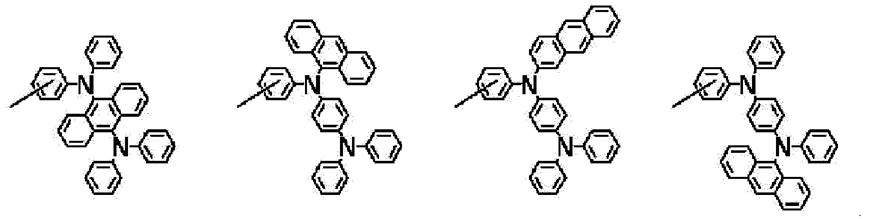 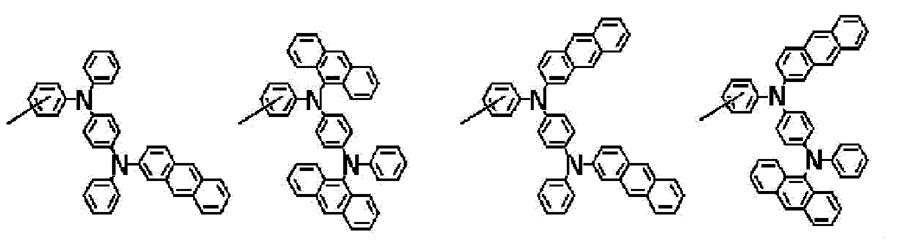 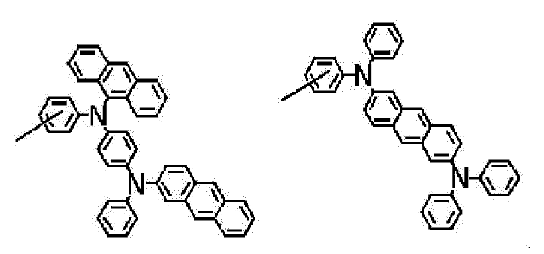 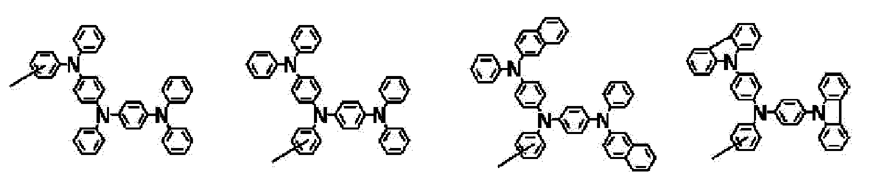 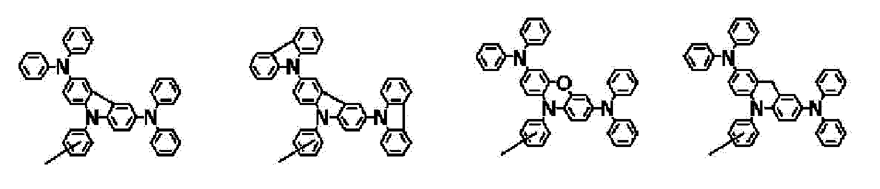 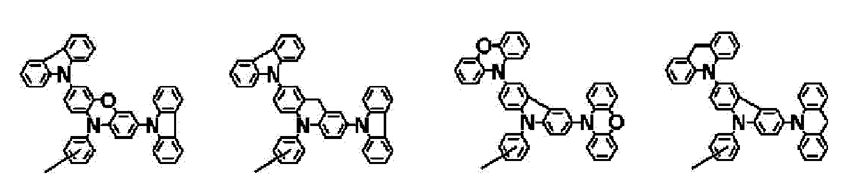 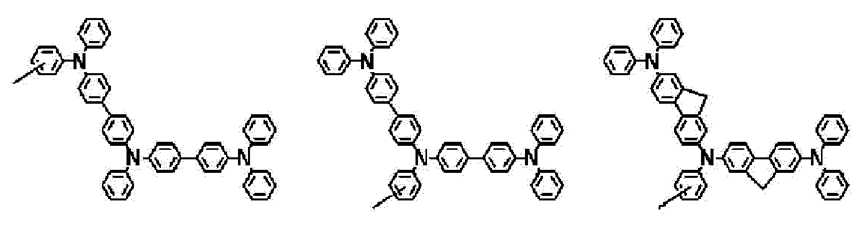 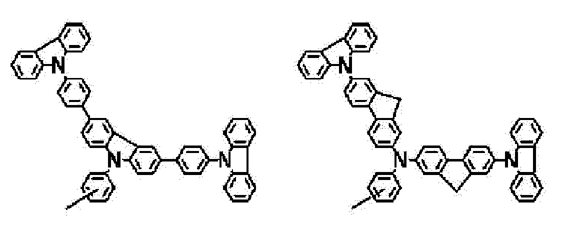 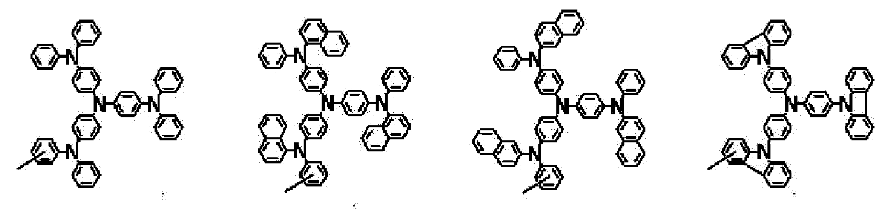 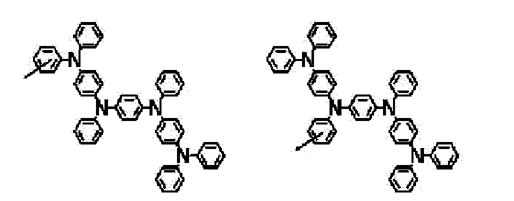 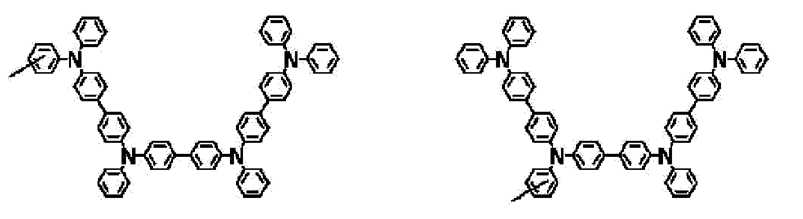 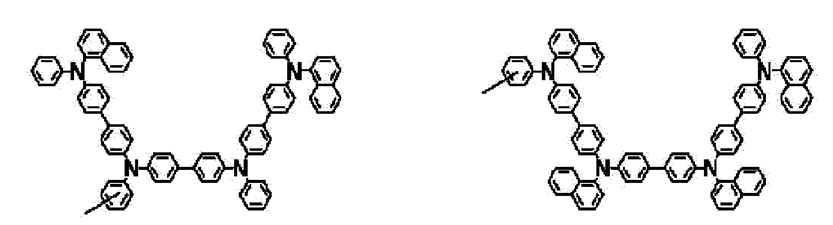 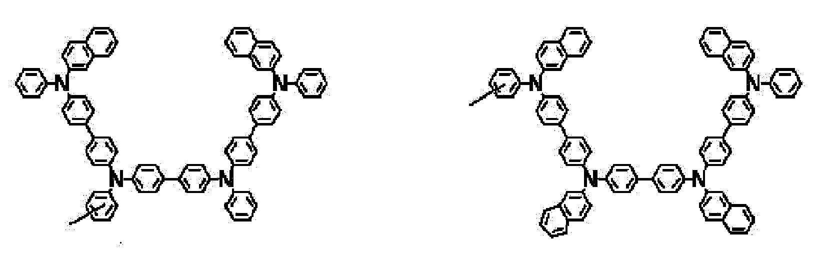 (wherein the bonding hand from the aromatic ring represents a bonding hand as is, or a bonding hand via an arylene group.)

From the perspective of solubility in the organic solvent, R¹, R², R⁹ and R¹⁰ in the formulae (1) and (2) are each preferably an alkyl group, an alkoxy group, or an aryl group, and more preferably an alkyl group or an aryl group.

Examples of the diyl group represented by the formula (1) may include the following diyl groups.

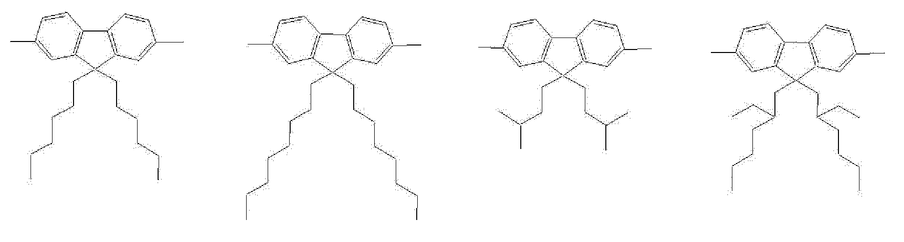

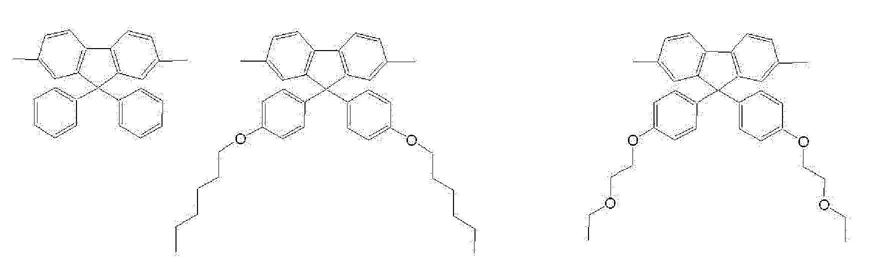

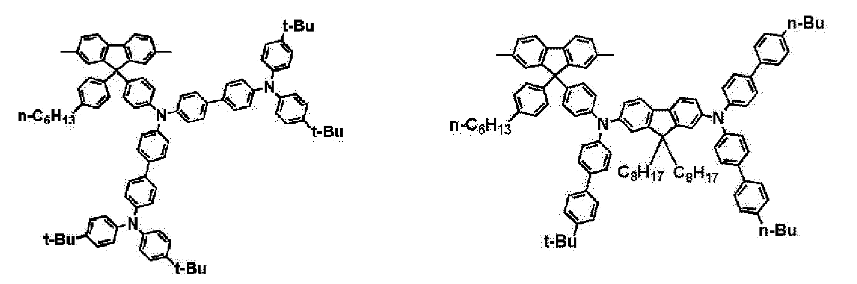

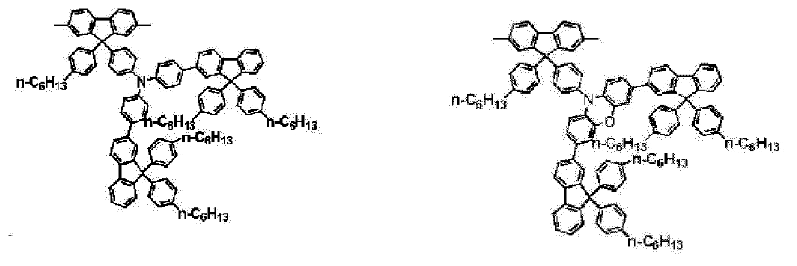

Examples of the diyl group represented by the formula (2) may include the following diyl groups.

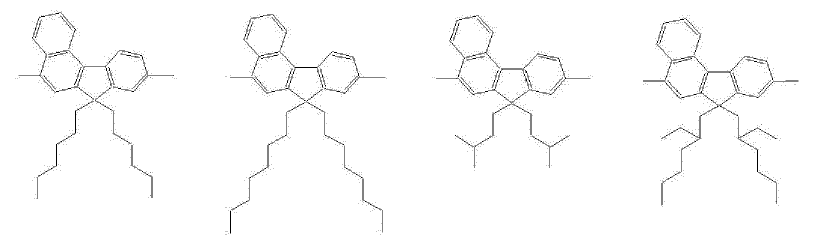

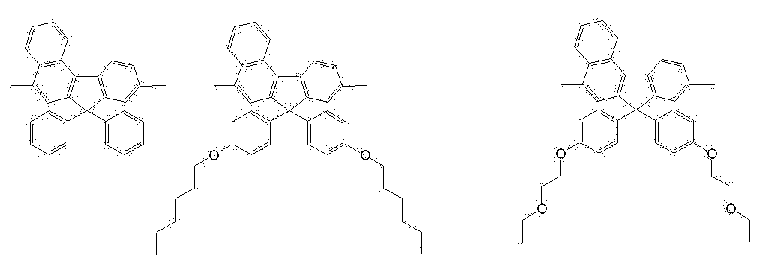

The light emitting polymer used in the present invention may be a homopolymer or a copolymer.

From the perspective of film-forming properties and solubility in a solvent, it is preferred that the light emitting polymer used in the present invention have a number average molecular weight of about 10³ to 10⁸ in terms of polystyrene, and more preferably of about 10³ to 10⁶ in terms of polystyrene. It is preferred that the light emitting polymer used in the present invention have a weight average molecular weight of 10³ to 1 × 10⁸ in terms of polystyrene, and more preferably of about 1 × 10³ to 1 × 10⁶ in terms of polystyrene.

The total amount of the unsubstituted or substituted fluorenediyl group and the unsubstituted or substituted benzofluorenediyl group in the light emitting polymer of the present invention is usually 10 mol% or more, and preferably 20 mol% or more, with respect to the total amount of repeating units that the light emitting polymer has.

The light emitting polymer used in the present invention may be a conjugated macromolecule or a nonconjugated macromolecule, and a conjugated macromolecule is preferred.

The conjugated macromolecule has meaning such as: (1) a macromolecule that is substantially formed from a structure in which a double bond and a single bond alternate; (2) a macromolecule that is substantially formed from a structure in which a double bond and a single bond are arranged with a nitrogen atom interposed therebetween; and (3) a macromolecule that is substantially formed from a structure in which a double bond and a single bond alternate and a structure in which a double bond and a single bond are arranged with a nitrogen atom interposed therebetween. In the present specification, the conjugated macromolecule is specifically a macromolecule having one or more kinds of diyl group selected from the group consisting of an unsubstituted or substituted fluorenediyl group and an unsubstituted or substituted benzofluorenediyl group as a repeating unit, in which the repeating units are bonded to each other directly or via a linking group. In addition to one or more kinds of diyl group selected from the group consisting of an unsubstituted or substituted fluorenediyl group and an unsubstituted or substituted benzofluorenediyl group, the conjugated macromolecule may have, as a repeating unit, one kind or two or more kinds of group selected from the group consisting of a dibenzofurandiyl group, an unsubstituted or substituted dibenzothiophenediyl group, an unsubstituted or substituted carbazolediyl group, an unsubstituted or substituted thiophenediyl group, an unsubstituted or substituted furandiyl group, an unsubstituted or substituted pyrrolediyl group, an unsubstituted or substituted benzothiadiazolediyl group, an unsubstituted or substituted phenylenevinylenediyl group, an unsubstituted or substituted thienylenevinylenediyl group, an unsubstituted or substituted triphenylaminediyl group, a phenoxazinediyl group, and a phenothiazinediyl group. The conjugated macromolecule may be a macromolecule that has the above repeating units bonded to each other directly or via a linking group in addition to the unsubstituted or substituted fluorenediyl group and unsubstituted or substituted benzofluorenediyl group.

When the repeating units are bonded to each other via a linking group in the conjugated macromolecule, examples of the linking group may include phenylene, biphenylene, naphthalenediyl, anthracenediyl and the like.

From the perspective of film-forming properties and solubility in the solvent, it is preferred that the conjugated macromolecule have a number average molecular weight of about 10³ to 10⁸ in terms of polystyrene, and more preferably of about 10³ to 10⁶ in terms of polystyrene. It is preferred that the conjugated macromolecule have a weight average molecular weight of about 10³ to 1 × 10⁸ in terms of polystyrene, and more preferably of about 1 × 10³ to 1 × 10⁶ in terms of polystyrene.

The ratio of sum of the molecular weights of the unsubstituted or substituted fluorenediyl group and the unsubstituted or substituted benzofluorenediyl group constituting the conjugated macromolecule to the molecular weight of the conjugated macromolecule is usually 0.3 or more, and preferably is 0.5 or more, provided that the molecular weight of the conjugated macromolecule is 1.

The conjugated macromolecule can be produced by synthesizing the monomers having a functional group suited to the used polymerization reaction, then, if necessary, dissolving in an organic solvent, and polymerizing by, for example, a polymerization method such as known aryl coupling using an alkali, a suitable catalyst and a ligand.

The polymerization method by aryl coupling is not particularly limited. Examples of the method may include: a method of polymerizing a monomer having a boric acid group or a boric acid ester group as a functional group suited to the polymerization reaction and a monomer having a halogen atom such as a bromine atom, an iodine atom and a chlorine atom, or a sulfonate group such as a trifluoromethanesulfonate group or a p-toluenesulfonate group as the functional group, in the presence of an inorganic base such as sodium carbonate, potassium carbonate, cesium carbonate, tripotassium phosphate and potassium fluoride, or an organic base such as tetrabutylammonium fluoride, tetrabutylammonium chloride, tetrabutylammonium bromide and tetraethylammonium hydroxide, by a Suzuki coupling reaction using a catalyst formed from a Pd complex or a Ni complex such as palladium [tetrakis(triphenylphosphine)], [tri(dibenzylideneacetone)] dipalladium, palladium acetate, bis(triphenylphosphine) palladium dichloride and bis(cyclooctadiene) nickel, and optionally a ligand such as triphenyl phosphine, tri(2-methylphenyl)phosphine, tri(2-methoxypheny)phosphine, diphenylphosphinopropane, tri(cyclohexyl)phosphine and tri(tert-butyl)phosphine; a method of polymerizing monomers each having a halogen atom or a sulfonate group such as a trifluoromethanesulfonate group, by a Yamamoto coupling reaction using a catalyst formed from a nickel(0) complex such as bis(cyclooctadiene) nickel, and a ligand such as bipyridyl, or using a catalyst formed from a Ni complex such as [bis(diphenylphosphino)ethane] nickel dichloride and [bis(diphenylphosphino)propane] nickel dichloride, and optionally a ligand such as triphenyl phosphine, diphenylphosphinopropane, tri(cyclohexyl)phosphine and tri(tert-butyl)phosphine, and a reducing agent such as zinc and magnesium, optionally conducting a reaction under dehydration conditions; a method of polymerizing by a Kumada-Tamao coupling reaction, in which polymerization is performed by an aryl coupling reaction, by reacting a compound having a halogenated magnesium group and a compound having a halogen atom using a Ni catalyst such as [bis(diphenylphosphino)ethane] nickel dichloride or [bis(diphenylphosphino)propane] nickel dichloride, under dehydration conditions; a method of polymerizing, with a hydrogen atom as a functional group, using an oxidizing agent such as FeCl₃; and an electrochemical oxidative polymerization method.

The reaction solvent is selected in consideration of the used polymerization reaction and the solubility of monomers and polymers, and the like. Specific examples may include an organic solvent such as tetrahydrofuran, toluene, 1,4-dioxane, dimethoxyethane, N,N-dimethylacetamide, N,N-dimethylformamide, and mixed solvents of two or more thereof; and a two-phase system of those solvents with water.

In the Suzuki coupling reaction, it is preferred to use an organic solvent such as tetrahydrofuran, toluene, 1,4-dioxane, dimethoxyethane, N,N-dimethylacetamide, N,N-dimethylformamide, and mixed solvents two or more thereof; or a two-phase system of those solvents with water. In order to suppress side-reactions, it is generally preferred to subject the reaction solvent to a deoxigenation treatment.

In the Yamamoto coupling reaction, it is preferred to use an organic solvent such as tetrahydrofuran, toluene, 1,4-dioxane, dimethoxyethane, N,N-dimethylacetamide, N,N-dimethylformamide, or mixed solvents two or more thereof. In order to suppress side-reactions, it is generally preferred to subject the reaction solvent to a deoxigenation treatment.

Among the above-described aryl coupling reactions, from the perspective of reactivity, the Suzuki coupling reaction and the Yamamoto coupling reaction are preferred, and a Suzuki coupling reaction or a Yamamoto coupling reaction that uses a nickel(0) complex is more preferred. Concerning a more detailed description of polymerization by Suzuki coupling, reference may be made to, for example, the known methods described in the Journal of Polymer Science: Part A: Polymer Chemistry, Vol. 39, 1533 - 1556 (2001). Concerning polymerization by Yamamoto coupling, reference may be made to, for example, the known methods described in Macromolecules 1992, 25, 1214 - 1223.

The reaction temperature in these reactions is not particularly limited, as long as it is within a temperature range where the reaction solution is kept in a liquid state. However, from the perspective of reactivity, a lower limit thereof is preferably -100°C, more preferably - 20°C, and especially preferably 0°C. From the perspective of stability of the conjugated macromolecule and the compound represented by the formulae (1) and (2), a upper limit thereof is preferably 200°C, more preferably 150°C, and especially preferably 120°C.

Extraction of the conjugated macromolecule can be performed according to a known method. For example, the conjugated macromolecule can be obtained by filtering a precipitate that was formed by adding the reaction solution to a lower alcohol such as methanol, and then drying the filtrated product. If the purity of the obtained conjugated macromolecule is low, the conjugated macromolecule can be purified using a common method such as recrystallization, continuous extraction using a Soxhlet extractor, and column chromatography.

The light emitting polymer composition according to the present invention may further comprise a solvent or dispersion medium in addition to the light emitting polymer and the fullerene and/or fullerene derivative. In other words, the light emitting polymer composition according to the present invention may be a liquid composition in which the light emitting polymer and the fullerene and/or fullerene derivative are dissolved in a solvent or dispersed in a dispersion medium.

For the solvent, a stable solvent that can uniformly dissolve or disperse the light emitting polymer and the fullerene and/or fullerene derivative can be appropriately selected from among known solvents. Such solvents may include alcohols (methanol, ethanol, isopropyl alcohol etc.), ketones (acetone, methyl ethyl ketone etc.), organic chlorines (chloroform, 1,2-dichloroethane etc.), aromatic hydrocarbons (benzene, toluene, xylene etc.), aliphatic hydrocarbons (normal hexane, cyclohexane etc.), amides (dimethylformamide etc.), and sulfoxides (dimethyl sulfoxide etc.). These solvents may be used alone or in combination of two or more thereof.

The content of the fullerene and/or fullerene derivative in the light-emitting layer is, with respect to 100 parts by weight of the light emitting polymer, usually from 0.001 part by weight to 10 parts by weight, preferably from 0.001 part by weight to 5 parts by weight, more preferably from 0.01 part by weight to 1 part by weight, and still more preferably from 0.05 part by weight to 1 part by weight.

When the light emitting polymer composition of the present invention comprises a solvent, the amount of solvent in the light emitting polymer composition is, with respect to a total of 100 parts by weight of the light emitting polymer and the fullerene and/or fullerene derivative, usually about 1,000 parts by weight to 100,000 parts by weight.

In addition to the light emitting polymer and the fullerene and/or fullerene derivative, the light emitting polymer composition of the present invention may comprise other components within a range that does not harm the electron transport properties and electron injection properties. The total content of the light emitting polymer and the fullerene and/or fullerene derivative in the organic EL element is, with respect to 100 parts by weight of the light-emitting layer, usually 30 parts by weight or more, preferably 50 parts by weight or more, and more preferably 70 parts by weight or more.

As described above, the organic EL element of the present invention comprises a pair of electrodes and a light-emitting layer provided between the electrodes, and the light-emitting layer comprises a light emitting polymer having one or more kinds of diyl group selected from the group consisting of an unsubstituted or substituted fluorenediyl group and an unsubstituted or substituted benzofluorenediyl group as a repeating unit, and a fullerene and/or fullerene derivative.

In addition to the light-emitting layer, the organic EL element may comprise a predetermined layer between the electrodes. Further, the organic EL element may have two or more light-emitting layers.

The organic EL element of the present embodiment comprises, as essential constituent elements, an anode, a cathode, and a light-emitting layer that is arranged between the anode and the cathode. Further, the organic EL element may also comprise another layer other than a light-emitting layer between the anode and the light-emitting layer and/or between the light-emitting layer and the cathode. The number of light-emitting layers between the anode and the cathode is not limited to one. A plurality of light-emitting layers may be provided therebetween.

Examples of layers that can be provided between the cathode and the light-emitting layer may include an electron injection layer, an electron transport layer, and a hole block layer. When both of the electron injection layer and the electron transport layer are provided between the cathode and the light-emitting layer, a layer in contact with the cathode is called the electron injection layer, and a layer other than the electron injection layer is called the electron transport layer.

The electron injection layer has a function of improving electron injection efficiency from the cathode. The electron transport layer has a function of improving electron injection from the layer in contact with the surface on the cathode side. The hole block layer has a function of blocking the transport of holes. When the electron injection layer and/or the electron transport layer have a function of blocking the transport of holes, such layer may also serve as the hole block layer.

The fact that the hole block layer has a function of blocking the transport of holes can be confirmed by, for example, preparing an element through which only a hole current flows, and confirming a blocking effect based on the reduction in the current value.

Examples of layers that can be provided between the anode and the light-emitting layer may include a hole injection layer, a hole transport layer, and an electron block layer. When both of the hole injection layer and the hole transport layer are provided between the anode and the light-emitting layer, a layer in contact with the anode is called the hole injection layer, and a layer other than the hole injection layer is called the hole transport layer.

The hole injection layer has a function of improving hole injection efficiency from the anode. The hole transport layer has a function of improving hole injection from the layer in contact with the surface on the cathode side. The electron block layer has a function of blocking the transport of electrons. When the hole injection layer and/or the hole transport layer have a function of blocking the transport of electrons, such layer may also serve as the electron block layer.

The fact that the electron block layer has a function of blocking the transport of electrons can be confirmed by, for example, preparing an element through which only an electron current flows, and confirming a blocking effect based on the reduction in the current value.

The electron injection layer and the hole injection layer may be collectively referred to as charge injection layers, and the electron transport layer and the hole transport layer may be collectively referred to as charge transport layers.

Examples of the layer structures which the organic EL element of the present embodiment can have are illustrated below.
a) Anode/light-emitting layer/cathode
b) Anode/hole injection layer/light-emitting layer/cathode
c) Anode/hole injection layer/light-emitting layer/electron injection layer/cathode
d) Anode/hole injection layer/light-emitting layer/electron transport layer/cathode
e) Anode/hole injection layer/light-emitting layer/electron transport layer/electron injection layer/cathode
f) Anode/hole transport layer/light-emitting layer/cathode
g) Anode/hole transport layer/light-emitting layer/electron injection layer/cathode
h) Anode/hole transport layer/light-emitting layer/electron transport layer/cathode
i) Anode/hole transport layer/light-emitting layer/electron transport layer/electron injection layer/cathode
j) Anode/hole injection layer/hole transport layer/light-emitting layer/cathode
k) Anode/hole injection layer/hole transport layer/light-emitting layer/electron injection layer/cathode
l) Anode/hole injection layer/hole transport layer/light-emitting layer/electron transport layer/cathode
m) Anode/hole injection layer/hole transport layer/light-emitting layer/electron transport layer/electron injection layer/cathode
n) Anode/light-emitting layer/hole injection layer/cathode
o) Anode/light-emitting layer/electron transport layer/cathode
p) Anode/light-emitting layer/electron transport layer/electron injection layer/cathode
(wherein a symbol "/" indicates the fact that the layers across the symbol "/" are adjacently stacked. The same shall apply hereinafter.)

The organic EL element of the present embodiment may comprise two or more light-emitting layers. When a stacked body interposed between the anode and the cathode in any one of the layer structures of a) to p) described above is indicated by a "structural unit A," an example of the structure of an organic EL element having two light-emitting layers may include the layer structure of q) below. The layer structure of the two "structural unit A" may be the same as or different from each other.
q) Anode/(structural unit A)/charge generation layer/(structural unit A)/cathode

When "(structural unit A)/charge generation layer" is indicated by a "structural unit B," an example of an organic EL element having three or more light-emitting layers may include the layer structure of r) below.
r) Anode/(structural unit B)x/(structural unit A)/cathode

In this structure, a symbol "x" represents an integer of 2 or more, and (structural unit B)x represents a stacked body in which the structural unit B is stacked x times. The layer structures of a plurality of (structural unit B) may be the same as or different from each other.

The organic EL element can be manufactured by successively stacking the above-described respective layers constituting the organic EL element on a supporting substrate by a predetermined method. For example, for the structures of a) to r) described above, the organic EL element can be manufactured by successively stacking, on a supporting substrate, the respective layers from left to right or from right to left.

### <Anode>

In an organic EL element having a structure in which light emitted from the light-emitting layer is output to the outside through the anode, a light-transmissive electrode is used for the anode. For the light-transmissive electrode, a thin film of a metal oxide, a metal sulfide, a metal and the like may be used, and an electrode with high electrical conductivity and high light transmittance is suitably used. Specifically, a thin film of indium oxide, zinc oxide, tin oxide, ITO, indium zinc oxide (Abbrev.: IZO), gold, platinum, silver, copper and the like is used. Of these, a thin film of ITO, IZO, or tin oxide is suitably used. The method for manufacturing the anode may include a vacuum deposition method, a sputtering method, an ion plating method, a plating method and the like. For the anode, an organic transparent conductive film of, for example, polyaniline or derivatives thereof, polythiophene or derivatives thereof may also be used.

The thickness of the anode is appropriately designed in consideration of required properties and simplicity of processes. The thickness is, for example, from 10 nm to 10 µm, preferably from 20 nm to 1 µm, and further preferably from 50 nm to 500 nm.

### <Cathode>

A material that has a low work function, facilitates electron injection into the light-emitting layer, and has high electrical conductivity is preferred as a material of the cathode. In an organic EL element in which light is extracted from the anode side, a material having high visible light reflectance is preferred as the material of the cathode because the cathode reflects the light irradiated from the light-emitting layer to the anode. For example, alkali metals, alkaline-earth metals, transition metals, and metals of Group 13 of the Periodic Table may be used for cathode. Examples of the cathode material may include a metal such lithium, sodium, potassium, rubidium, cesium, beryllium, magnesium, calcium, strontium, barium, aluminum, scandium, vanadium, zinc, yttrium, indium, cerium, samarium, europium, terbium and ytterbium; an alloy of two or more of the metals; an alloy of one or more of the metals and one or more of gold, silver, platinum, copper, manganese, titanium, cobalt, nickel, tungsten and tin; and graphite or a graphite intercalation compound. Examples of the alloy may include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. For the cathode, a transparent conductive electrode made of a conductive metal oxide, a conductive organic substance, or the like can be used. Specific examples of the conductive metal oxide may include indium oxide, zinc oxide, tin oxide, ITO, and IZO. Specific examples of the conductive organic substance may include polyaniline or derivatives thereof and polythiophene or derivatives thereof. The cathode may be formed of a stacked body in which two or more layers are stacked. Further, the electron injection layer may be used as the cathode.

The thickness of the cathode is appropriately designed in consideration of required properties and simplicity of processes. The thickness is, for example, from 10 nm to 10 µm, preferably from 20 nm to 1 µm, and more preferably from 50 nm to 500 nm.

Methods for manufacturing the cathode may include a vacuum deposition method, a sputtering method, a lamination method in which a metal thin film is thermocompression bonded, and the like.

### <Light-Emitting Layer>

It is preferred that the light-emitting layer is formed by an applying method. An applying method is preferred in that it can simplify the manufacturing processes and the productivity thereof is excellent. The applying methods may include a casting method, a spin coating method, a bar coating method, a blade coating method, a roll coating method, a gravure printing method, a screen printing method, an inkjet method and the like. When forming the light-emitting layer using such an applying method, firstly a composition in a solution state that comprises the light emitting polymer, the fullerene and/or fullerene derivative, and a solvent is prepared as an applying liquid, and this applying liquid is applied on a desired layer or electrode by a predetermined applying method. Then, the applying liquid is dried to form a light-emitting layer having a desired thickness.

### <Other Layers>

The materials for the hole injection layer, hole transport layer, electron injection layer, electron transport layer and the like are not particularly limited. These layers are formed by a predetermined film-forming method such as an applying method, a vacuum deposition method, a sputtering method, and a lamination method.

The above-described organic EL element can be suitably used in a light-emitting device such as a curved or a flat illumination device, e.g., a planar light source used for a light source of scanner, and a display device.

The display device comprising an organic EL element may include a segment display device, a dot-matrix display device and the like. Examples of a dot-matrix display device may include an active matrix display device and a passive matrix display device. In an active matrix display device or a passive matrix display device, the organic EL element is used as the light-emitting element forming each pixel. In a segment display device, the organic EL element is used as the light-emitting element forming each segment or as a backlight. In a liquid crystal display device, the organic EL element is used as a backlight.

### Examples

Examples will now be illustrated in order to describe the present invention in more detail. However, the present invention is not limited to these Examples.

### - Method for measuring molecular weight -

In the Examples, the number average molecular weight (Mn) and the weight average molecular weight (Mw) were determined in terms of polystyrene by gel permeation chromatography (GPC). Specifically, the molecular weight was measured at 40°C by GPC (trade name: HLC-8220GPC, manufactured by Tosoh Corporation) using three TSKgel SuperHM-H (manufactured by Tosoh Corporation) columns connected in series. Tetrahydrofuran was used as a developing solvent, and was flowed at a flow rate of 0.5 mL/min. A differential refractive index detector was used for the detector.

### <Synthesis Example 1> (Synthesis of macromolecular compound 1)

Into a 500 ml four-necked flask, 1.72 g of triscaprylylmethylammonium chloride (trade name: Aliquat 336), 6.2171 g of the compound A represented by the following formula,

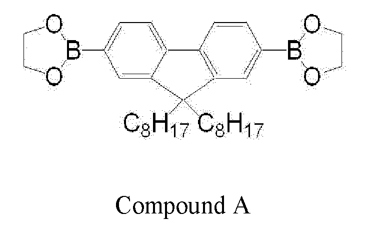

0.5085 g of the compound B represented by the following formula:

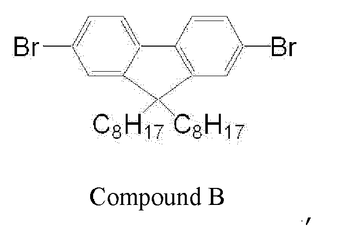

6.2225 g of the compound C represented by the following formula: 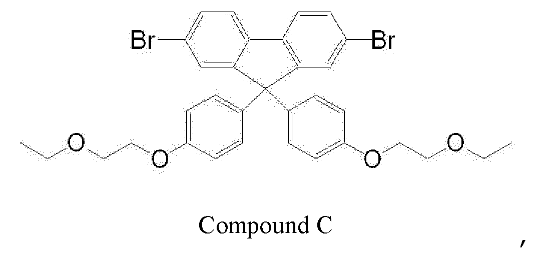 and 0.5487 g of the compound D represented by the following formula: 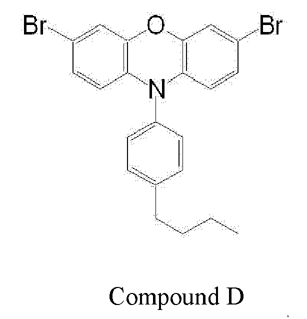 were charged, and then the flask was purged with nitrogen. One hundred milliliters of toluene was added, then 7.6 mg of dichlorobis(triphenylphosphine) palladium(II) and 24 ml of an aqueous solution of sodium carbonate were added, and the resultant mixture was stirred for 3 hours under reflux. Then, 0.40 g of phenylboric acid was added, and the mixture was stirred overnight. An aqueous solution of sodium N,N-diethyldithiocarbamate was added, and the mixture was further stirred for 3 hours under reflux. The resultant reaction liquid was then separated. The organic phase was washed with an acetic acid aqueous solution and water, and then added dropwise into methanol, whereby a precipitate was formed. The resultant precipitate was filtrated, dried under reduced pressure, dissolved in toluene, passed through a silica gel-alumina column, and then washed with toluene. The obtained toluene solution was added dropwise into methanol, whereby a precipitate was formed. The obtained precipitate was filtrated, dried under reduced pressure, and then dissolved in toluene. The resultant mixture was added dropwise into methanol, whereby a precipitate was formed. The obtained precipitate was filtrated, and dried under reduced pressure, thus obtaining 7.72 g of macromolecular compound 1 (conjugated macromolecule). The number average molecular weight Mn of the macromolecular compound 1 in terms of polystyrene was 1.2 × 10⁵, and the weight average molecular weight Mw in terms of polystyrene was 2.9 × 10⁵.

### <Synthesis Example 2> (Synthesis of macromolecular compound 2)

Into a 5 L separable flask, 40.18 g of triscaprylylmethylammonium chloride (trade name: Aliquat 336), 234.06 g of the compound A represented by the following formula:

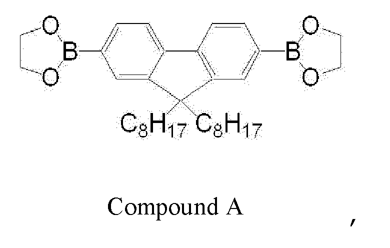

172.06 g of the compound E represented by the following formula: 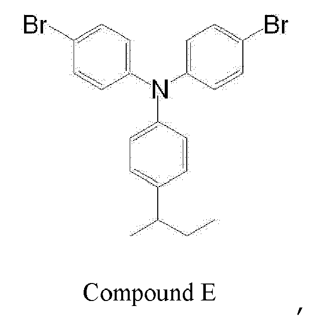 and 28.5528 g of the compound F represented by the following formula: 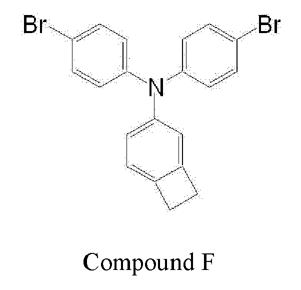 were charged, and then the flask was purged with nitrogen. Then, 2,620 g of toluene bubbled with argon was added, and the mixture was bubbled for further 30 minutes while stirring. Thereto, 99.1 mg of palladium acetate and 937.0 mg of tris(o-tolyl)phosphine were added. The mixture was rinsed with 158 g of toluene, and heated to 95°C. Next, 855 g of 17.5% by weight of an aqueous solution of sodium carbonate was added dropwise, and then a bath temperature was increased to 110°C. The mixture was stirred for 9.5 hours, and then a solution in which 5.39 g of phenylboric acid was dissolved in 96 ml of toluene was added. The mixture was stirred for 14 hours, and then 200 ml of toluene was added. The resultant reaction liquid was then separated. The organic phase was washed twice with 850 ml of 3% by weight of an aqueous solution of acetic acid, and then 850 ml of water and 19.89 g of sodium N,N-diethyldithiocarbamate were added, and the resultant mixture was stirred for 4 hours. After separating, the mixture was passed through a silica gel-alumina column, and then washed with toluene. The obtained toluene solution was added dropwise into 50 L of methanol, whereby a precipitate was formed. The obtained precipitate was washed with methanol, dried under reduced pressure, and then dissolved in 11 L of toluene. The obtained toluene solution was added dropwise into 50 L of methanol, whereby a precipitate was formed. The obtained precipitate was filtrated, and dried under reduced pressure, thus obtaining 278.39 g of macromolecular compound 2. The number average molecular weight Mn of the macromolecular compound 2 in terms of polystyrene was 7.7 × 10⁴, and the weight average molecular weight Mw in terms of polystyrene was 3.8 × 10⁵.

The above-described compounds A to F can be synthesized by the method described in, for example, WO 2005/52027.

The monomer compounds M1 and M3 described below and the macromolecular compound P9 in Synthesis Example 3 illustrated below can be synthesized by the method described in JP 2009-149850 A.

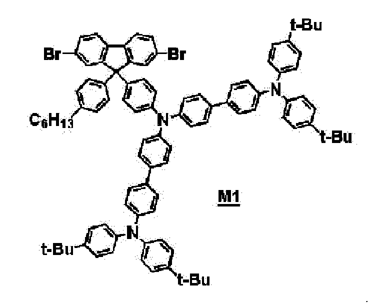

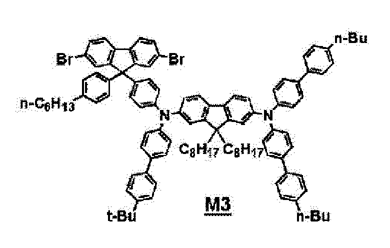

### <Synthesis Example 3> (Synthesis of macromolecular compound P9)

Under an argon gas atmosphere, 2,7-bis(1,3,2-dioxaborolan-2-yl)-9,9-dioctylfluorene (1.0675 g, 2.012 mmol), 2,7-dibromo-9,9-dioctylfluorene (0.8873 g, 1.618 mmol), the compound M1 (0.3782 g, 0.263 mmol), the compound M3 (0.1622 g, 0.101 mmol), N-(4-n-butylphenyl)-3,7-dibromophenoxazine (the compound D) (0.0191 g, 0.040 mmol), and trioctylmethylammonium chloride (trade name: Aliquat 336, manufactured by Aldrich) (0.26 g, 0.65 mmol) were dissolved in toluene (20 ml). After bubbling argon gas into the solution, the temperature of the resultant solution was increased to 80°C, and then dichlorobistriphenylphosphine palladium (2.8 mg, 4.0 µmol) and 17.5% by weight of an aqueous solution of sodium carbonate (5.5 ml, 9.1 mmol) were added. The mixture was reacted for 7 hours under reflux. The resultant mixture was temporarily cooled, and then phenylboric acid (0.02 g, 0.2 mmol) and dichlorobistriphenylphosphine palladium (1.4 mg, 2.0 µmol) were added, and the mixture was further reacted for 2 hours under reflux. Toluene (20 ml) was added to dilute the mixture. The aqueous layer was removed. Thereto, 9% by weight of an aqueous solution of sodium N,N-diethyldithiocarbamate (12 ml) was added. After stirring the mixture at 90°C for 2 hours, the organic layer was washed twice with ion-exchanged water (26 ml), twice with 3% by weight of an aqueous solution of acetic acid (26 ml), and twice with ion-exchanged water (26 ml) in this order. Next, the mixture was added dropwise into methanol (300 ml), and stirred for 30 minutes. The precipitated polymer was collected by filtration, washed with methanol (60 ml), and then dried under reduced pressure to obtain a crude polymer.

This crude polymer was dissolved in toluene (80 ml), passed through alumina (14 g) and a silica gel (31 g) packed in a column, and then toluene (50 ml) was passed therethrough. The obtained solution was added dropwise into methanol (300 ml), and stirred for 30 minutes. The precipitated polymer was collected by filtration, washed with methanol (60 ml), and then dried under reduced pressure, thus obtaining the macromolecular compound P9 that is a polymer (1.38 g, yield 72%). The number average molecular weight Mn of the macromolecular compound P9 in terms of polystyrene was 1.2 × 10⁵, and the weight average molecular weight Mw in terms of polystyrene was 3.3 × 10⁵. The glass transition temperature was 109°C. The fluorescence peak wavelengths of the thin film were 446 nm and 462 nm.

Based on the raw materials, it is considered that the macromolecular compound P9 comprises the following repeating units in the following ratio (molar ratio).

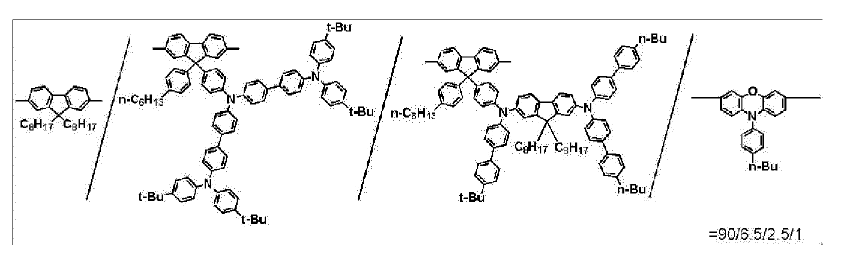

### <Preparation of applying solution A1>

The macromolecular compound 1 was dissolved in xylene at a concentration of 1.0% by weight, and then the solution was filtrated through a Teflon (registered trademark) filter having a pore size of 0.2 µm, thus preparing an applying solution A1.

### <Preparation of applying solution B>

The macromolecular compound 2 was dissolved in xylene at a concentration of 0.5% by weight, and then the solution was filtrated through a Teflon (registered trademark) filter having a pore size of 0.2 µm, thus preparing an applying solution B.

### <Preparation of applying solution A2>

The macromolecular compound 1 was dissolved in xylene at a concentration of 1.0% by weight, and [6,6]-phenyl C61-butyric acid methyl ester (PCBM) (ADS61BFB, manufactured by American Dye Source, Inc.) as a fullerene derivative was dissolved in the solution {macromolecular compound 1 : PCBM = 100:0.2 (weight ratio)}. The resultant solution was filtrated through a Teflon (registered trademark) filter having a pore size of 0.2 µm, thus preparing an applying solution A2.

### <Preparation of applying solution A3>

The macromolecular compound 1 was dissolved in xylene at a concentration of 1.0% by weight, and [6,6]-phenyl C61-butyric acid methyl ester (PCBM) (ADS61BFB, manufactured by American Dye Source, Inc.) as a fullerene derivative was dissolved in the solution {macromolecular compound 1 : PCBM = 100:0.1 (weight ratio)}. The resultant solution was filtrated through a Teflon (registered trademark) filter having a pore size of 0.2 µm, thus preparing an applying solution A3.

### <Preparation of applying solution A4>

The macromolecular compound 1 was dissolved in xylene at a concentration of 1.0% by weight, and [6,6]-phenyl C61-butyric acid methyl ester (PCBM) (ADS61BFB, manufactured by American Dye Source, Inc.) as a fullerene derivative was dissolved in the solution {macromolecular compound 1 : PCBM = 100:0.01 (weight ratio)}. The resultant solution was filtrated through a Teflon (registered trademark) filter having a pore size of 0.2 µm, thus preparing an applying solution A4.

### <Preparation of applying solution A5>

The macromolecular compound P9 was dissolved in xylene at a concentration of 1.0% by weight, and then the resultant solution was filtrated through a Teflon (registered trademark) filter having a pore size of 0.2 µm, thus preparing an applying solution A5.

### <Preparation of applying solution A6>

The macromolecular compound P9 was dissolved in xylene at a concentration of 1.0% by weight, and [6,6]-phenyl C61-butyric acid methyl ester (PCBM) (ADS61BFB, manufactured by American Dye Source, Inc.) as a fullerene derivative was dissolved in the solution {macromolecular compound 1 : PCBM = 100:0.1 (weight ratio)}. The resultant solution was filtrated through a Teflon (registered trademark) filter having a pore size of 0.2 µm, thus preparing an applying solution A6.

### (Preparation and evaluation of organic EL element)

### <Example 1>

On a glass substrate having, as an anode, an ITO film (film thickness: 150 nm) formed thereon by sputtering, a solution for forming a hole injection layer (trade name: HIL764, manufactured by Plextronics, Inc.) was spin-coated. The resultant substrate was dried on a hot plate at 170°C for 15 minutes in air, thus forming a hole injection layer (thickness: 50 nm). Next, the applying solution B was spin-coated onto the hole injection layer, and the resultant substrate was baked in a glove box at 180°C for 60 minutes under a nitrogen atmosphere, thus forming a hole transport layer (thickness: 20 nm). Then, the applying solution A2 was spin-coated onto the hole transport layer, thus forming a light-emitting layer. The light-emitting layer was formed such that the layer had a thickness of 80 nm.

Subsequently, the resultant substrate was baked on a hot plate at 130°C for 10 minutes under a nitrogen atmosphere. Then, NaF was vapor deposited thereonto in a thickness of 4 nm, and A1 was vapor deposited thereonto in a thickness of 100 nm, thus forming a cathode.

The degree of vacuum during vapor deposition was in the range of 1 × 10⁻⁴ Pa to 9 × 10⁻³ Pa. The shape of the element was a 2 mm × 2 mm regular tetragon. The obtained element was driven at a constant current and an initial brightness of 5,000 cd/m² to perform a life test. The time until the initial brightness was reduced to 4,000 cd/m² (80% of the initial brightness) was measured (this time is referred to as LT80). The EL emission chromaticity at a brightness of 100 cd/m², specifically, the coordinate value in the chromaticity coordinates (C.I.E. 1931), was measured. The measurement results are shown in Table 1.

### <Example 2>

An organic EL element was prepared by the same method as in Example 1, except that the applying solution A3 was used instead of the applying solution A2. Further, the LT80 and the chromaticity of the organic EL element were measured by the same method as in Example 1. The measurement results are shown in Table 1.

### <Example 3>

An organic EL element was prepared by the same method as in Example 1, except that the applying solution A4 was used instead of the applying solution A2. Further, the LT80 and the chromaticity of the organic EL element were measured by the same method as in Example 1. The measurement results are shown in Table 1.

### <Example 4>

An organic EL element was prepared by the same method as in Example 1, except that the applying solution A6 was used instead of the applying solution A2. Further, the LT80 and the chromaticity of the organic EL element were measured by the same method as in Example 1. The measurement results are shown in Table 1.

### <Comparative Example 1>

An organic EL element was prepared by the same method as in Example 1, except that the applying solution A1 was used instead of the applying solution A2. Further, the LT80 and the chromaticity of organic EL element were measured by the same method as in Example 1. The measurement results are shown in Table 1.

### <Comparative Example 2>

An organic EL element was prepared by the same method as in Example 1, except that the applying solution A5 was used instead of the applying solution A2. Further, the LT80 and the chromaticity of organic EL element were measured by the same method as in Example 1. The measurement results are shown in Table 1.

**Table 1**

| | LIGHT-EMITTING LAYER | LT80 (hours) | Chromaticity Chromaticity Coordinates (x, y) |
|---|---|---|---|
| Example 1 | Macromolecular compound 1 / PCBM = 100/0.2 (weight ratio) | 12 | 0.14,0.19 |
| Example 2 | Macromolecular compound 1 / PCBM = 100/0.1 (weight ratio) | 7 | 0.14, 0.20 |
| Example 3 | Macromolecular compound 1 / PCBM = 100/0.01 (weight ratio) | 0.75 | 0.15, 0.21 |
| Example 4 | Macromolecular compound P9 / PCBM = 100/0.1 (weight ratio) | 3 | 0.14,0.14 |
| Comparative Example 1 | Macromolecular compound 1 | 0.6 | 0.16, 0.22 |
| Comparative Example 2 | Macromolecular compound P9 | 0.4 | 0.15, 0.17 |

As can be seen from Table 1, the organic EL element including the light-emitting layer that comprises the light emitting polymer (the macromolecular compound 1) and the fullerene and/or fullerene derivative has a much better LT80 life than an organic EL element including a light-emitting layer that is formed only from a light emitting polymer when the initial brightness was the same. Therefore, it is confirmed that the organic EL element including the light-emitting layer that comprises the light emitting polymer composition of the present invention has an excellent element life. Further, by forming a light-emitting layer comprising a light emitting polymer that has a substituent represented by the formula (4), an organic EL element having blue emission color with high purity could be obtained.

### Industrial Applicability

According to the present invention, an organic EL element having an improved element life can be realized.

## Claims

1. An organic electroluminescent element comprising: a pair of electrodes composed of an anode and a cathode; and a light-emitting layer provided between the electrodes, wherein the light-emitting layer comprises,
a light emitting polymer having one or more kinds of diyl group, as a repeating unit, selected from the group consisting of an unsubstituted or substituted fluorenediyl group and an unsubstituted or substituted benzofluorenediyl group, and
a fullerene and/or a fullerene derivative.

2. The organic electroluminescent element according to claim 1, wherein the fullerene derivative is a methanofullerene derivative, a phenyl butyric acid methyl ester derivative, a thienyl butyric acid methyl ester derivative, a Prato derivative, a Bingel derivative, a diazoline derivative, an azafulleroid derivative, a ketolactam derivative, or a Diels-Alder derivative.

3. The organic electroluminescent element according to claim 1 or 2, wherein the unsubstituted or substituted fluorenediyl group is a group represented by formula (1): 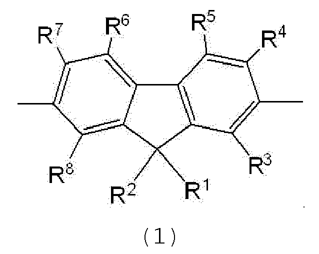 wherein R¹, R², R³, R⁴, R⁵, R⁶, R⁷ and R⁸ each independently represent a hydrogen atom, an alkyl group, an alkoxy group, an aryl group, or a monovalent aromatic heterocyclic group;
and a hydrogen atom included in these groups may be substituted with a fluorine atom.

4. The organic electroluminescent element according to any one of claims 1 to 3, wherein the unsubstituted or substituted benzofluorenediyl group is a group represented by the following formula (2): 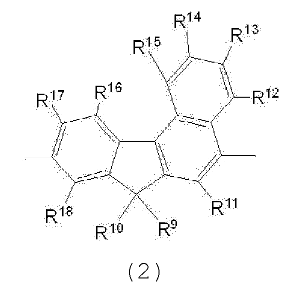 wherein R⁹, R¹⁰, R¹¹, R¹², R¹³, R¹⁴, R¹⁵, R¹⁶, R¹⁷ and R¹⁸ each independently represent a hydrogen atom, an alkyl group, an alkoxy group, an aryl group, or a monovalent aromatic heterocyclic group; and a hydrogen atom included in these groups may be substituted with a fluorine atom.

5. The organic electroluminescent element according to any one of claims 1 to 4, wherein the light emitting polymer is a conjugated macromolecule.

6. The organic electroluminescent element according to any one of claims 1 to 5, wherein a content of the fullerene and/or fullerene derivative in the light-emitting layer is from 0.001 part by weight to 5 parts by weight with respect to 100 parts by weight of the light emitting polymer.

7. The organic electroluminescent element according to any one of claims 1 to 5, wherein a content of the fullerene and/or fullerene derivative in the light-emitting layer is from 0.01 part by weight to 1 part by weight with respect to 100 parts by weight of the light emitting polymer.

8. A light-emitting device comprising the organic electroluminescent element of any one of claims 1 to 7.

9. A light emitting polymer composition, comprising:
a light emitting polymer having one or more kinds of diyl group, as a repeating unit, selected from the group consisting of an unsubstituted or substituted fluorenediyl group and an unsubstituted or substituted benzofluorenediyl group; and
a fullerene and/or a fullerene derivative.

10. The light emitting polymer composition according to claim 9, wherein the fullerene derivative is a methanofullerene derivative, a phenyl butyric acid methyl ester derivative, a thienyl butyric acid methyl ester derivative, a Prato derivative, a Bingel derivative, a diazoline derivative, an azafulleroid derivative, a ketolactam derivative, or a Diels-Alder derivative.

11. The light emitting polymer composition according to claim 9 or 10, wherein the unsubstituted or substituted fluorenediyl group is a group represented by formula (1): 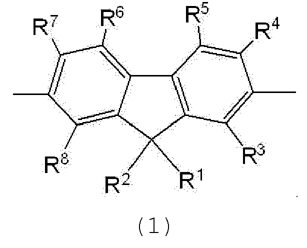 wherein R¹, R², R³, R⁴, R⁵, R⁶, R⁷ and R⁸ each independently represent a hydrogen atom, an alkyl group, an alkoxy group, an aryl group, or a monovalent aromatic heterocyclic group; and a hydrogen atom included in these groups may be substituted with a fluorine atom.

12. The light emitting polymer composition according to any one of claims 9 to 11, wherein the unsubstituted or substituted benzofluorenediyl group is a group represented by the following formula (2): 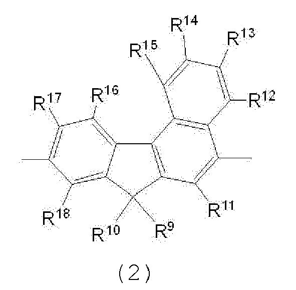 wherein R⁹, R¹⁰, R¹¹, R¹², R¹³, R¹⁴, R¹⁵, R¹⁶, R¹⁷ and R¹⁸ each independently represent a hydrogen atom, an alkyl group, an alkoxy group, an aryl group, or a monovalent aromatic heterocyclic group; and a hydrogen atom included in these groups may be substituted with a fluorine atom.

13. The light emitting polymer composition according to any one of claims 9 to 12, wherein the light emitting polymer is a conjugated macromolecule.

14. The light emitting polymer composition according to any one of claims 9 to 13, wherein a content of the fullerene and/or fullerene derivative is from 0.001 part by weight to 5 parts by weight with respect to 100 parts by weight of the light emitting polymer.

15. The light emitting polymer composition according to any one of claims 9 to 13, wherein a content of the fullerene and/or fullerene derivative is from 0.01 part by weight to 1 part by weight with respect to 100 parts by weight of the light emitting polymer.
